# EUROPEAN PATENT APPLICATION

(11) **EP 1 341 222 A1**
(43) Date of publication of application: **03.09.2003**
(21) Application number: 02447031.2
(22) Date of filing: 28.02.2002
(51) Int. Cl.: H01L 21/20, C30B 23/02

(54) **A method for producing a device having a semiconductor layer on a lattice mismatched substrate**

(71) Applicant: Interuniversitair Micro-Elektronica Centrum, 3001 Heverlee (BE); Umicore, 1000 Brussels (BE)
(72) Inventor: Flamand, Giovanni, 2110 Wijnegem (BE); Poortmans, Jef, 3010 Leuven (BE)
(74) Representative: Van Malderen, Joelle

(57) **Abstract**

The present invention relates to a layer stack comprising a monocrystalline layer located upon a porous surface of a substrate, said monocrystalline layer and said substrate being significantly lattice mismatched, obtainable by a process comprising a sublimation or an evaporation step by emission from a source and an incomplete filling step of said porous surface by said sublimated or evaporated emission.

## Description

### Field of the invention

The present invention relates to a dislocation-free monocrystalline (epitaxial layer) on a substrate when a significant lattice mismatch exists between said substrate and said monocrystalline layer. The present invention equally relates to a method for growing said dislocation-free monocrystalline layer on top of said substrate.

### State of the art

In a large variety of semiconductor devices, it is desirable to have a monocrystalline layer sequence of lattice mismatched materials. For example, the hetero-epitaxial growth of different types of semiconductor film such as Ge, GeₓSi₁₋ₓ or Group III-V semiconductor such as GaAs on a Si substrate could allow the monolithic integration of special function devices e.g. optical detectors, laser, light-emitting diodes (LEDs) or high speed transistor with Si ultra large scale integrated circuits. Alternatively the epitaxial growth of highband gap semiconductors on the most common substrates such as Si could lead to a cheaper, high volume realisation of short wavelength diode lasers (yellow, green, blue and ultraviolet) or multi-junction monolithic cascade solar cells.

For many years attempts have been made to grow various epitaxial layers on significantly lattice mismatched substrates by conventional techniques such as chemical vapour deposition (CVD) or molecular beam epitaxy (MBE). By 'significantly lattice mismatched' it is meant that the substrate and the epitaxial layer differ in their lattice constants by at least 0.3%, preferably 0.5%. In the text, the words epitaxial and monocrystalline are used as synonyms.

In the case of CVD, it is not easy to realise high conversion efficiency from gaseous precursors to the desired semiconductor layer on the substrate without negatively affecting uniformity. In the case of MBE, the yield is higher but the complexity of the associated equipment is large. The resulting epitaxial layers always contain a large number of defects because of the difference in lattice constant and thermal expansion coefficient between the host substrate and the grown crystal.

Documents US-A-4 806 996 and US-A-5 981 400 describe a method for overcoming significant lattice mismatches, which consists in making the base material porous at the top surface or in patterning the top surface of the base layer before growing the other material by conventional techniques.

M.T. Currie et al. in App. Phys. Lett. volume 72, number 14, page 1718, describes a method to grow epitaxial Ge on Si which uses a graded Si/Ge buffer layer deposited by ultra high vacuum chemical vapour deposition (UHVCVD). However the method is complex and expensive.

The fact that no commercial devices have appeared on the market gives an indication that none of the method described in the mentioned prior art leads to the growth of high quality layer, with high degree of crystallinity. It is known that the desirable properties of a layer are usually enhanced by the degree of crystallinity of the layer itself. For instance, the electron mobility and the band gap value are directly related to the crystallinity of the semiconductor layer. Therefore the high quality of the grown crystal is a fundamental requirement for fabricating working devices.

### Aims of the invention

The present invention aims to provide a device in the form of a layer stack which does not have the drawbacks of the state of the art.

Furthermore, the present invention aims to provide a method for producing such a device.

More particularly, the present invention aims to provide a dislocation-free monocrystalline layer on a substrate when significant lattice mismatch exists between said substrate and said monocrystalline layer.

The present invention equally aims to provide a simple method to grow said dislocation-free monocrystalline layer on top of said substrate.

### Summary of the invention

According to a first object, the present invention is related to a method for producing a device in the form of a layer stack comprising a dislocation-free monocrystalline layer located upon the porous surface of a substrate, said monocrystalline layer and said substrate being significantly lattice mismatched. In particular said method comprises a step of growing said dislocation free monocrystalline layer. Before said step,a sublimation or an evaporation step of material from a source is performed and an incomplete or partial filling of said porous surface of said substrate by said sublimated or evaporated material is obtained.

The present invention is also related to a device in the form of a layer stack comprising a dislocation-free monocrystalline layer located upon the porous top surface of a substrate, said monocrystalline layer and said substrate being significantly lattice mismatched, wherein said porous surface is partially filled with sublimated or evaporated material, said device being obtainable by the method described hereabove.

In a preferred embodiment, the dislocation free monocrystalline layer located on the porous surface of said substrate is obtained by close space vapour transport (CSVT) process.

Preferably, the monocrystalline layer is essentially germanium and the substrate is essentially silicon.

Another object of the present invention is to provide a method for producing a free standing device in the form of a layer stack, comprising a dislocation-free monocrystalline layer located upon a porous surface of a substrate, said monocrystalline layer and said substrate being significantly lattice mismatched. In particular said method comprises a step of growing said dislocation-free monocrystalline layer. Before said step, a sublimation or an evaporation step of material from a source is performed and an incomplete or partial filling of said porous surface of said substrate by said sublimated or said evapored material is obtained.

The present invention is also related to the free standing device in the form of a layer stack comprising a dislocation-free monocrystalline layer located upon a porous surface of a substrate, said monocrystalline layer and said substrate being significantly lattice mismatched, wherein said porous surface is partially filled with sublimated or evaporated material, said device being obtainable by the method described hereabove.

Said device obtained by the method described hereabove can be made free standing from the substrate by a lift-off process.

By free standing it should be understood a device which is able to support itself after being submitted to a deformation.

In a preferred embodiment, the dislocation free monocrystalline layer located on the porous surface of said substrate is obtained by close space vapour transport (CSVT) process.

Preferably, the monocrystalline layer is essentially germanium and the substrate is essentially silicon.

The devices in the form of layer stacks described hereabove may be used for semiconductor applications such as optical detectors, laser, light-emitting diodes or high-speed transistor.

### Short description of the drawings

The invention will be described in more details with reference to the attached drawings.

Figure 1 represents the schematic set-up used for the deposition of epitaxial Ge onto a porous surface of a Si wafer according to the first embodiment.

Figure 2 represents the Si porous surface partially filled with sublimated or evaporated Ge.

Figure 3 represents the schematic set-up used for the deposition of epitaxial Ge onto a porous surface of a Si wafer according to the second embodiment.

Figure 4 represents the XRD pattern of epitaxial Ge layer grown onto a porous surface of a Si wafer.

Figure 5 represents the schematic set-up used for the deposition of epitaxial Ge onto a porous surface of a Si wafer according to the third embodiment.

### Detailed description of the several embodiments of the invention

In a first aspect of the present invention, a dislocation-free monocrystalline layer is grown onto a significant lattice mismatched substrate by the methods illustrated in the following embodiments.

In a first embodiment, a dislocation-free epitaxial Ge layer is grown onto the top surface of a Si substrate. A lattice mismatch of about 4% exists between the Si substrate and the Ge layer. Therefore a porous layer is first formed at the surface of the Si substrate. Said forming step of a porous layer may be done by an anodization technique or according to any other known method. Said porous layer may have a porosity profile of the type lower/higher/lower or higher/lower and the porosity may vary between 20 and 70%. The thickness of said porous layer may range between 100 nm to 20 nm. The Ge material is then sublimated from a Ge source.

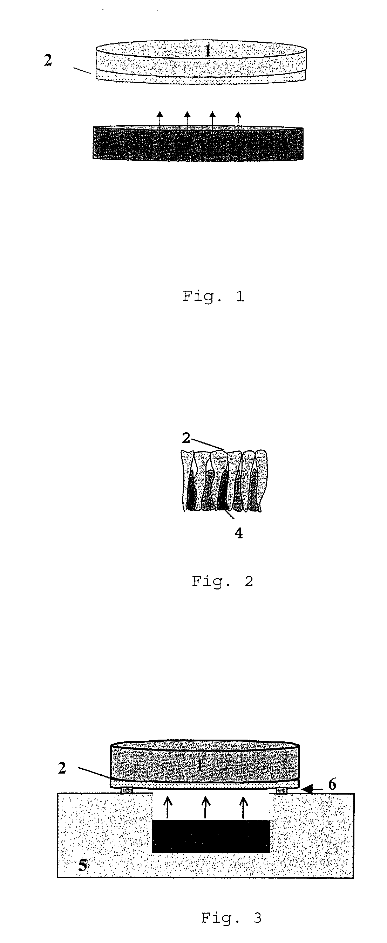

Figure 1 illustrates the schematic experimental set-up employed in the first embodiment.

A wafer consisting in a Si substrate(1) having a porous Si layer (2) is placed in said set-up and a Ge wafer (3) serves as a Ge source for the sublimated or evaporated material.

Both wafers are placed opposite to each other, separated only by a few hundreds µm thick spacer (not shown). When the system is brought to a temperature ranging from 700 to 930°C under an H₂-atmosphere, sublimation of Ge occurs. The Si pores start to be filled with sublimated Ge material(4) the filling is a function of time. After 1 hour for example, Si pores are filled with Ge to a depth of about 600 nm. According to Rutherford backscattering (RBS) analysis, 30% Ge is present at the Si/porous Si substrate when the surface porosity is about 30%, and the Ge content linearly decreases over the depth and an empty space is still present underneath such a Si/Ge graded layer as shown in Figure 2.

In a second embodiment a dislocation free epitaxial Ge layer is grown onto a Si substrate by forming a porous layer at the surface of the Si substrate as described in the first embodiment, followed by the sublimation of Ge onto the porous Si at a temperature of between 950 and 1000°C under an H₂-atmosphere.

In this case, the Si(1)/porous Si(2) wafer is placed over a graphite susceptor (5) only separated from it by thin spacers (6) as shown in Figure 3.

The first wafer consists in a Si substrate (1) on which a porous Si layer (2) is created. A second wafer which is a bulk Ge wafer(3) is placed as a source of evaporated material in a cavity of the graphite susceptor. At 936°C, Ge melts, starts to evaporate and diffuses into the pores in the Si wafer. The distance between the bulk Ge wafer and the Si wafer is approximately 1 cm. The Si pores start filling with evaporated Ge (4) and the filling is function of time. For example, after 1 hour Si pores are filled with Ge to a depth of about 600 nm. According to Rutherford backscattering (RBS) analysis, 30% Ge is present at the Si/porous Si substrate when the surface porosity is about 30%, and the Ge content linearly decreases over the depth and an empty space is present underneath such a Si/Ge graded layer as shown in Figure 2.

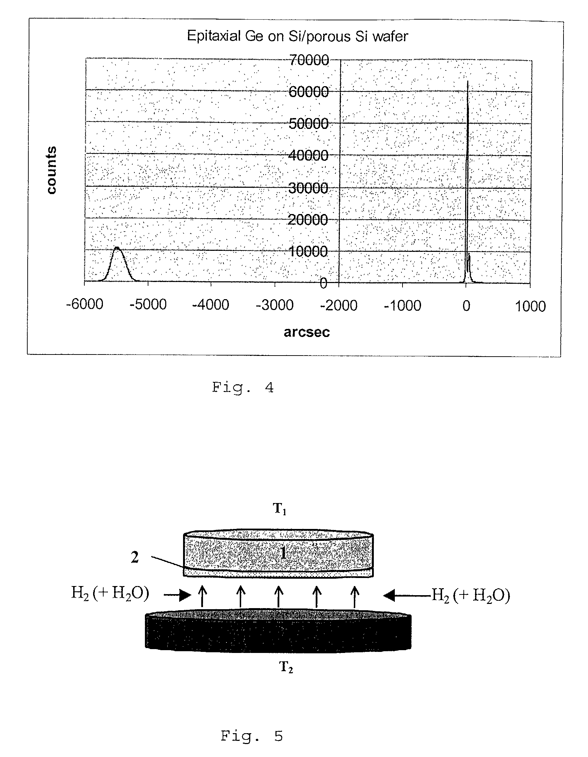

In both first and second embodiments, dislocation-free epitaxial Ge is grown on top of the obtained graded Si/Ge layer by plasma enhanced CVD technique to the desired thickness. The fact that the Ge is epitaxial is evidenced by the XRD analysis shown in Figure 4. At 0 arcsec two peaks are observed, one from the Si-wafer and one from the porous Si layer. At -5500 arcsec there is a peak belonging to the Ge layer grown on top. Any other growth technique such as UHCVD, metal organic chemical vapour deposition (MOCVD), MBE, could be successfully employed to grow epitaxial Ge after the formation of the Si/Ge graded layer by sublimation. In fact, the stress related to the growth of epitaxial Ge is largely relieved by the presence of empty pores underneath the Si/Ge graded layer.

In a third embodiment of the present invention, a porous layer is first formed at the surface of the Si substrate as described in the first embodiment. Dislocation-free epitaxial Ge of the desired thickness on the wafer consisting in Si substrate(1) on which porous Si(2) layer is then grown in one step by a close space vapour transport (CSVT) process as schematically shown in Figure 5.

The CSVT technique relies on the temperature difference between the sublimation source and the receiving substrate. In the present enbodiment, the Ge source (3) is placed at a distance of a few tenths of mm from the Si(1)/porous Si(2) wafer. The temperature (T₁) of the Si/porous Si substrate is always kept hundreds of degrees lower that the temperature (T₂) of the Ge source. The experiments are performed in H₂ atmosphere, with the addition of water vapour . When T₂ is high enough at the desired pressure, Ge starts to sublimate Ge (4) first diffuses in the Si pores of the Si(1)/porous Si (2) substrate, after that epitaxial Ge starts to grow on top of the Si/Ge graded layer.

It should be emphasised that in spite of the fact that CSVT process is not recognised as a conventional technique by the IC world, it has a lot of advantages. CSVT has a high yield, is relatively simple if compared to CVD or MBE techniques, and does not require vacuum. In addition, CSVT process can be applied on large scale and is therefore interesting for industrial use.

According to another aspect of the present invention, a device in the form of layer stack comprising a dislocation-free monocrystalline layer located upon a porous surface of a substrate is obtained, the monocrystalline layer and the substrate being significantly lattice mismatched. Such a device is advantageously obtained by the CSVT technique or by any of the techniques described above which in first instance fill the pores of the porous Si by sublimation or evaporation of material from a source.

Preferably, the substrate is Si because it is available in large sizes (>8 inch) with a high degree of crystallography (very low defect density < 1 cm⁻²) and mechanical perfection. Moreover, it features a high mechanical strength and a thermal conductivity several times higher than many other semiconductors. However, other semiconductor substrates could serve the scope. Analogously, other materials than Ge, selected from the group III-V semiconductor such as GaAs could be grown as dislocation-free monocrystalline layers on a Si substrate.

An additional aspect of the present invention discloses a free-standing device in the form of a layer stack made of a dislocation-free monocrystalline layer onto a porous carrier. Said free standing layer stack can be obtained by a lift-off process. For example, the graded Si/Ge layer formed at the interface between porous Si and Ge, according to the previous embodiments described above, can be lifted off from the Si-substrate to realise a free-standing Ge-film partially filled Si-carrier. Said Si carrier provides the necessary mechanical strength for the Ge-film and acts as a complying substrate for the Ge film resulting in a material with lower defect density. Said lift-off of the Si/Ge layer can be done either mechanically or by wet chemistry or if the porosity profile in partially filled Si layer is large enough even spontaneously.

This proves that this technique can be used to realise free-standing, porous Si/Ge templates (5) as illustrated in Figure 5.

The realisation of dislocation-free Ge epitaxial layer on Si substrate could serve as starting platform for the growth of GaAs and/or AlGaAs for the realisation of reliable low-cost GaAs-based optical, electronic or optoelectronic devices and could pave the way to monolithic integration of silicon and compound semiconductor devices.

## Claims

1. A device in the form of a layer stack comprising a dislocation-free monocrystalline layer located upon the porous surface (2) of a substrate (1), said monocrystalline layer and said substrate being significantly lattice mismatched, said device being obtainable by a method of forming said device comprising a sublimation step or an evaporation step of material from a source (3) and an incomplete or partial filling step of said porous surface (2) of said substrate by said sublimated or evaporated material before the step of growing the dislocation-free monocrystalline layer.

2. A device as in claim 1, wherein the monocrystalline layer is germanium and the substrate is silicon.

3. A device as in claim 1 or 2, wherein said monocrystalline layer is obtainable by a close space vapour transport process.

4. A free standing device in the form of a layer stack comprising a dislocation-free monocrystalline layer located upon the porous surface (2) of a substrate (1), said monocrystalline layer and said substrate being significantly lattice mismatched, said device being obtainable by a method of forming said device comprising a sublimation step or an evaporation step of material from a source (3) and an incomplete or partial filling step of said porous surface (2) of said substrate by said sublimated or evaporated material before the step of growing the dislocation-free monocrystalline layer.

5. A free standing device as in claim 4, wherein the monocrystalline layer is germanium and the substrate is silicon.

6. A free standing device as in claim 4 or 5, wherein said monocrystalline 10 ayer is obtainable by a close space vapour transport process.

7. A method for producing a device in the form of a layer stack comprising a dislocation-free monocrystalline layer located upon a porous surface on a substrate, said monocrystalline layer and said substrate being significantly lattice mismatched, said method comprising :
- the step of forming a porous layer on the surface of said substrate;
- the step of sublimating or evaporating material from a source;
- the step of filling partially or incompletely said porous surface of said substrate by said sublimated or evaporated material;
- the step of growing the dislocation-free monocrystalline layer on said substrate.

8. A method as in claim 7 said wherein the monocrystalline layer is grown by close space vapour transport process.

9. A method as in claim 7 or 8 wherein said layer stack is lifted of from said substrate.

10. Method as in claim 8 or 9, wherein the source material is germanium and the porous surface is silicon.

11. Use of a layer stack as in any of the previous claims to 6 for semiconductor applications such as optical detectors, laser, light-emitting diodes or high-speed transistor.
